# EUROPEAN PATENT APPLICATION

(11) **EP 2 416 384 A1**
(43) Date of publication of application: **08.02.2012**
(21) Application number: 10761359.8
(22) Date of filing: 26.03.2010
(51) Int. Cl.: H01L 31/042, B32B 27/30

(54) **REAR SURFACE PROTECTION SHEET FOR SOLAR CELL MODULE AND SOLAR CELL MODULE**

(30) Priority: 30.03.2009 JP 2009081271
(71) Applicant: Lintec Corporation, Tokyo 173-0001 (JP)
(72) Inventor: MORI, Takeshi, Tokyo 173-0001 (JP)
(74) Representative: Jansen, Cornelis Marinus
(86) International application number: PCT/JP2010/002167
(87) International publication number: WO 2010/116651

(57) **Abstract**

A back protective sheet for a solar cell module in which a fluorine resin layer is formed on at least one side of a base sheet, wherein an inorganic pigment (A) having a large mean particle diameter and an inorganic pigment (B) having a small mean particle diameter are contained in the fluorine resin layer, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments (A) and (B) is within the range of 50 parts by weight to 130 parts by weight based on 100 parts by weight of the fluorine resin.

## Description

### TECHNICAL FIELD

The present invention relates to a back protective sheet for a solar cell module, and to a solar cell module provided with the same.
The present application claims priority on the basis of Japanese Patent Application No. 2009-81271 filed in Japan on March 30, 2009, the contents of which are incorporated herein by reference.

### BACKGROUND ART

Solar cell modules are devices that convert light energy from the sun into electrical energy, and are attracting attention as systems capable of generating electrical power without discharging carbon dioxide. These solar cell modules are required to not only have high electric power generation efficiency, but also have durability that enables them to withstand long-term use even in cases when used outdoors.

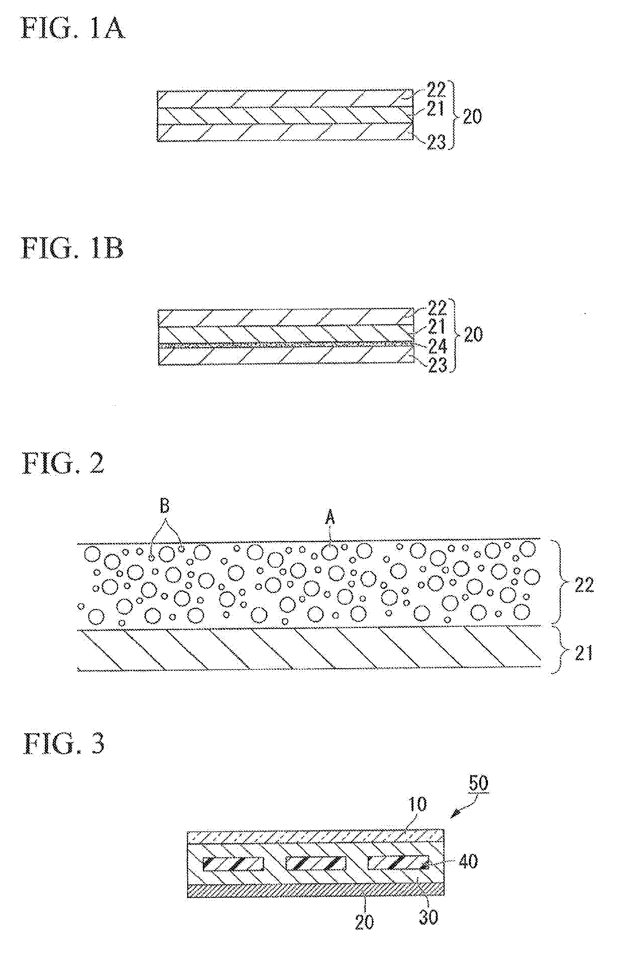

FIG. 3 is a schematic diagram showing an example of a solar cell module.
A solar cell module 50 is mainly composed of solar cells 40 serving as photovoltaic power generation elements, an encapsulant 30 serving as an electrical insulator that prevents short-circuiting of electrical circuits, a front protective sheet 10 laminated onto the front of the encapsulant 30, and a back protective sheet 20 laminated onto the back of the encapsulant 30.

In order to impart weather resistance and durability to the solar cell module 50 enabling it to withstand outdoor and indoor use over a long period of time, it is necessary to protect the solar cells 40 and the encapsulant 30 from wind and rain, humidity, dust and mechanical impacts while also maintaining the inside of the solar cell module 50 in a sealed state that is isolated from the outside air. Consequently, the front protective sheet 10 and the back protective sheet 20 are required to have superior weather resistance, and are required to have a low level of water vapor permeability in particular.
In addition, it is also necessary for the back protective sheet to have durability and light reflectivity.

As an example of a technology for improving gas barrier properties with respect to water vapor or oxygen and the like, Patent Document 1 discloses a back sheet for a solar cell module provided with a light diffusing layer having roughly uniform fine protrusions or indentations on one side thereof, and a metal deposition layer having light reflectivity and gas barrier properties.

### [Prior Art Documents]

### [Patent Documents]

[Patent Document 1] Japanese Unexamined Patent Application, First Publication No. 2006-319250

### SUMMARY OF THE INVENTION

### Problems to be Solved by the Invention

However, in the case of the back sheet for a solar cell module disclosed in Patent Document 1, it is difficult to uniformly form the metal deposition layer in the case the metal deposition layer is formed so as to contact a bead coating layer, thereby resulting in the occurrence of locations of defective deposition and the risk of exacerbation of gas barrier properties.
In addition, this back sheet also has the problem of high production cost due to the formation of a metal deposition film.
Moreover, this back sheet also has problems with quality and productivity, such as requiring a step for forming a metal deposition film and a step for laminating with other members.

With the foregoing in view, an object of the present invention is to provide a back protective sheet for a solar cell module that has superior gas barrier properties and can be produced easily and inexpensively.

### Means for Solving the Problems

In order to solve the aforementioned problems, the present invention provides a back protective sheet for a solar cell module in which a fluorine resin layer is formed on at least one side of a base sheet; wherein, an inorganic pigment (A) having a large mean particle diameter and an inorganic pigment (B) having a small mean particle diameter are contained in the fluorine resin layer, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments (A) and (B) is within the range of 50 parts by weight to 130 parts by weight based on 100 parts by weight of the fluorine resin.

The mean particle diameter (DA) of the inorganic pigment (A) having a large mean particle diameter is preferably within the range of 1,500 nm to 12,000 nm, and the mean particle diameter (DB) of the inorganic pigment (B) having a small mean particle diameter is preferably within the range of 10 nm to 800 nm.

In the back protective sheet for a solar cell module of the present invention, the weight ratio (WB/WA) of the added amount (WB) of the inorganic pigment (B) having a small mean particle diameter to the added amount (WA) of the inorganic pigment (A) having a large mean particle diameter is preferably within the range of 2.0 to 15.0.

In the back protective sheet for a solar cell module of the present invention, the inorganic pigments (A) and (B) are preferably one type or two or more types selected from the group consisting of titanium dioxide, surface-treated titanium dioxide, silica and surface-treated silica.

In addition, the present invention provides a solar cell module provided with the aforementioned back protective sheet for a solar cell module on the back side thereof.

### Effects of the Invention

Since the back protective sheet for a solar cell module of the present invention is a back protective sheet for a solar cell module having a fluorine resin layer containing inorganic pigment, wherein an inorganic pigment (A) having a large mean particle diameter and an inorganic pigment (B) having a small mean particle diameter are contained in the fluorine resin layer, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments (A) and (B) is 50 parts by weight to 130 parts by weight based on 100 parts by weight of the fluorine resin, when a fluorine resin layer is formed by coating a coating liquid containing a fluorine resin and the inorganic pigments onto a base sheet, a structure can be formed that is denser than in the case of using inorganic pigment having a single diameter, thereby allowing the formation of a fluorine resin layer having high gas barrier properties.
In addition, in the case of increasing the inorganic pigment content of a coating liquid in order to form a dense structure using inorganic pigment of a single diameter, although the viscosity of the coating liquid becomes extremely high, resulting in poor coating aptitude and causing the formation of streaks and air bubbles, according to the present invention, since inorganic pigments having different mean particle diameters are contained in a fluorine resin layer, a dense structure can be formed without having to excessively increase the inorganic pigment content in the coating liquid, thereby preventing the viscosity of the coating liquid from becoming excessively high and resulting in favorable coating aptitude.
Moreover, the back protective sheet for a solar cell module of the present invention has superior blocking properties on the side of the fluorine resin layer, and even in the case of winding the sheet into a roll and storing, the sheet is resistant to the occurrence of blocking even when unwound.

Since the solar cell module of the present invention is provided with the back protective sheet for a solar cell module according to the present invention on the back side of the module, it has superior water vapor impermeability and weather resistance, and maintains durability enabling it to withstand outdoor use for a long period of time.

### BRIEF DESCRIPTION OF THE DRAWINGS

FIG. 1A is a cross-sectional view of an example of a back protective sheet for a solar cell module of the present invention.
FIG. 1B is a cross-sectional view of another example of a back protective sheet for a solar cell module of the present invention.
FIG. 2 is an enlarged view of the essential portion of FIG. 1A and FIG. 1B.
FIG. 3 is a schematic block diagram of a solar cell module of the present invention.

### EMBODIMENTS OF THE INVENTION

FIG. 3 is a schematic block diagram of a solar cell module that uses the back sheet for a solar cell module of the present invention (to be referred to as a back sheet).
As shown in FIG. 3, this solar cell module 50 employs a configuration having solar cells 40, an encapsulant 30 that covers the solar cells 40, a front sheet 10 fixed to the front (light receiving surface) of the encapsulant 30, and a back sheet 20 adhered to the back of the encapsulant 30. In order to impart weather resistance and durability capable of withstanding long-term indoor and outdoor use to the solar cell module, it is necessary to protect the solar cells 40 and the encapsulant 30 from wind and rain, humidity, dust and mechanical impacts, and maintain the inside of the solar cell module in a sealed state that is isolated from the outside air. Consequently, the back sheet 20 is required to have high water vapor impermeability.

FIGS. 1A and 1B are cross-sectional views showing examples of the structure of the back sheet of the present invention.
The back sheet 20 in FIG. 1A employs a configuration in which a fluorine resin layer 22 is formed at least one side of a base sheet 21, and an adhesive layer 23 is formed directly on the other side of the base sheet 21. The back sheet 20 of FIG. 1B employs a configuration in which the fluorine resin layer 22 is formed on one side of the base sheet 21, and the adhesive layer 23 is formed on the other side of the base sheet 21 through a laminating adhesive layer 24.
The fluorine resin layer 22 contains an inorganic pigment (A) having a large mean particle diameter and an inorganic pigment (B) having a small mean particle diameter, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments is 50 parts by weight to 130 parts by weight based on 100 parts by weight of the fluorine resin.

A resin sheet that is typically used as a resin sheet in a solar cell module protective sheet can be used for the resin sheet able to be used for the base sheet 21. Examples of this sheet include sheets composed of resins such as polyethylene, polypropylene, polystyrene, methyl polymethacrylate, polytetrafluoroethylene, polyamide (Nylon 6, Nylon 66), polyacrylonitrile, polyvinyl chloride, polyethylene terephthalate (PET), polybutylene terephthalate (PBT), polyethylene naphthalate (PEN), polyoxymethylene, polycarbonate, polyphenylene oxide, polyester urethane, poly-m-phenylene isophthalamide, poly-p-phenylene terephthalamide, acrylic resin, acrylonitrile-butadiene- styrene resin (ABS resin), epoxy resin, polystyrene-polycarbonate alloy resin and phenol resin. In particular, a sheet composed of a polyester such as PET, PBT or PEN is preferable, while more specifically, a PET sheet is more preferable.
In addition, the base sheet 21 composed of polyester such as the aforementioned PET, PBT or PEN, to which has been imparted resistance to hydrolysis using a known method, is more preferable. In the case of using these preferable resin sheets for the base sheet 21, the water vapor impermeability, electrical insulating properties, heat resistance and chemical resistance of the back sheet 20 can be further improved.

Furthermore, the base sheet 21 may also contain various types of additives such as an organic filler, inorganic filler or ultraviolet absorber. In addition, a vapor deposition layer for enhancing weather resistance or moisture resistance and the like may be further provided on the surface of the base sheet 21. The vapor deposition layer is formed by a chemical vapor deposition such as plasma-enhanced chemical vapor deposition, thermochemical vapor deposition or photochemical vapor deposition, or a physical vapor deposition such as vacuum deposition, sputtering or ion plating. The vapor deposition layer is composed of an inorganic oxide, and that composed of a metal oxide such as silicon dioxide (SiO₂) or aluminum oxide (Al₂O₃) is preferable. One type of these metal compounds may be used alone or two or more types may be used in combination. In addition, the vapor deposition layer may be a single layer or consist of two or more layers.

The thickness of the base sheet 21 is selected based on the electrical insulating properties required by the solar cell system. For example, in the case the base sheet 21 is a resin sheet, the film thickness thereof is preferably within the range of 10 µm to 300 µm. More specifically, in the case the base sheet 21 is a PET sheet, the thickness of the PET sheet is preferably within the range of 10 µm to 300 µm, more preferably within the range of 30 µm to 200 µm, and even more preferably within the range of 50 µm to 150 µm, from the viewpoints of light weight and electrical insulating properties.

In the present embodiment, the fluorine resin layer 22 is formed by coating a coating liquid containing a fluorine-containing polymer serving as a base resin, inorganic pigments having different mean particle diameters as previously described, and a solvent, onto at least one side of the base sheet 21 and then drying. In the fluorine resin layer 22 formed in this manner, the aforementioned inorganic pigments having different mean particle diameters form a dense structure in which the inorganic pigment (B) having a small particle diameter is incorporated in the gaps between the inorganic pigment (A) having a large particle diameter as a result of both the inorganic pigment (A) having a large particle diameter and the inorganic pigment (B) having a small particle diameter being present as shown in FIG 2. On the other hand, in the case the fluorine resin layer 22 contains inorganic pigment having a single diameter that has been prepared to have a single mean particle diameter or have a particle size distribution that falls within an extremely limited range, gaps between the inorganic pigment particles become numerous, thereby preventing the formation of a dense structure as shown in FIG. 2.

Although there are no particular limitations on the fluorine-containing resin incorporated in the coating liquid provided it is a resin that contains fluorine and does not impair the effects of the prevent invention, that which dissolves in the solvent (organic solvent or water) of the coating liquid and is capable of crosslinking is preferable. Preferable examples of the fluorine-containing resin include polymers composed mainly of chlorotrifluoroethylene (CTFE), such as Lumiflon (trade name) manufactured by Asahi Glass Co., Ltd., Cefral Coat (trade name) manufactured by Central Glass Co., Ltd. or Fluonate (trade name) manufactured by DIC Corp., and polymers composed mainly of tetrafluoroethylene (TFE) such as Zeffle (trade name) manufactured by Daikin Industries, Ltd.

The aforementioned Lumiflon (trade name) is an amorphous polymer containing as main constituent units thereof CTFE and several types of specific alkyl vinyl ethers and hydroxyalkyl vinyl ethers. Polymers having monomer units of hydroxyalkyl vinyl ethers in the manner of Lumiflon (trade name) are preferable since they demonstrate superior solvent solubility, crosslinking reactivity, base adhesion, pigment dispersibility, hardness and flexibility.
The aforementioned Zeffle (trade name) is a copolymer of TFE and an organic solvent-soluble hydrocarbon olefin, and in the case of having a hydrocarbon olefin provided with a highly reactive hydroxyl group in particular, the use thereof is preferable since it demonstrates superior solvent solubility, crosslinking reactivity, base adhesion and pigment dispersibility.

A polymer of a fluoroolefin having a curable functional group can also be used for the fluorine-containing resin, and examples of curable functional groups include hydroxyl groups, carboxyl groups, amino groups and glycidyl groups.

In addition, a monomer that is copolymerizable with the fluorine-containing resin may be incorporated in the coating liquid, and examples of such monomers include vinyl esters of carboxylic acids such as vinyl acetate, vinyl propionate, butyl acetate, vinyl isobutyrate, vinyl pivalate, vinyl caproate, vinyl versatate, vinyl laurate, vinyl stearate, vinyl cyclohexylcarbonate or vinyl benzoate, and alkyl vinyl ethers such as methyl vinyl ether, ethyl vinyl ether, butyl vinyl ether and cyclohexyl vinyl ether.

Moreover, the fluorine-containing resin incorporated in the coating liquid may be a polymer composed of one or more types of monomers or may be a terpolymer. Examples of terpolymers include Dyneon THV (trade name, 3M Corp.), which is a terpolymer of VdF, TFE and hexafluoropropylene. Such multi-lateral polymers are preferable since they are able to impart the characteristics of each of the monomers to the polymer. For example, the aforementioned Dyneon THV (trade name) is preferable since it can be produced at a comparatively low temperature, is able to adhere to elastomers and hydrocarbon-based plastics, and has superior flexibility and optical transparency.

There are no particular limitations on the solvent contained in the coating liquid provided it does not impair the effects of the present invention, and examples of solvents that can be used preferably include one or more types thereof selected from the group consisting of methyl ethyl ketone (MEK), cyclohexanone, acetone, methyl isobutyl ketone (MIBK), toluene, xylene, methanol, isopropanol, ethanol, heptane, ethyl acetate, isopropyl acetate, n-butyl acetate and n-butyl alcohol. From the viewpoints of solubility of the base resin component in the coating liquid, low rate of remaining in the coated film (low boiling point temperature) and silica dispersibility, the solvent more preferably includes one or more types of solvents selected from the group consisting of xylene, cyclohexanone and MEK.

The fluorine resin layer 22 is preferably cured with a crosslinking agent in order to improve weather resistance and scratch resistance. There are no particular limitations on the crosslinking agent provided it does not impair the effects of the present invention, and examples of crosslinking agents that are used preferably include metal chelates, silanes, isocyanates and melamines. In the case of assuming that the back sheet is to be used outdoors for 30 years or more, an aliphatic isocyanate is preferable for the crosslinking agent from the viewpoint of weather resistance.

The inorganic pigment incorporated in the coating liquid contains an inorganic pigment (A) having a large mean particle diameter and an inorganic pigment (B) having a small mean particle diameter, particle diameter are contained in the fluorine resin layer, the diameter ratio (DB/DA) of the mean particle diameter (DB) of the inorganic pigment (B) to the mean particle diameter (DA) of the inorganic pigment (A) is within the range of 0.01 to 0.3 and preferably within the range of 0.05 to 0.2, and two types or three or more types can be selected from various types of inorganic pigments having various mean particle diameters and incorporated in the coating liquid. If the diameter ratio (DB/DA) of the inorganic pigments (A) and (B) is within the range of 0.01 to 0.3, a dense structure is formed in the fluorine resin layer 22 in which the inorganic pigment (B) having a small particle diameter is incorporated in gaps between the inorganic pigment (A) having a large particle diameter as shown in FIG. 2. If the diameter ratio (DB/DA) of the inorganic pigments (A) and (B) is outside the aforementioned range, it becomes difficult for the inorganic pigments to form a dense structure in the fluorine resin layer 22, thereby resulting in a decrease in the gas barrier properties of the back sheet 20.

The amount of the inorganic pigments (A) and (B) (total weight of the inorganic pigments) added to the coating liquid is within the range of 50 parts by weight to 130 parts by weight, and preferably within the range of 70 parts by weight to 110 parts by weight, based on 100 parts by weight of the fluorine resin in terms of the solid fraction thereof. If the added amount of inorganic pigments is less than 50 parts by weight, the inorganic pigment content in the fluorine resin layer 22 formed becomes excessively low, thereby preventing the obtaining of the effect of improving gas barrier properties. On the other hand, if the added amount of the inorganic pigments exceeds 130 parts by weight, the viscosity of the coating liquid becomes extremely high, coating aptitude becomes poor, and it becomes difficult to form a favorable coated surface of the fluorine resin layer 22, while also facilitating separation of the fluorine resin layer 22 due to poor adhesion between the base sheet 21 and the fluorine resin layer 22.

The inorganic pigment (A) having a large mean particle diameter preferably has a mean particle diameter (DA) of 1,500 nm to 12,000 nm, and more preferably has a mean particle diameter within the range of 2,000 nm to 10,000 nm.

The inorganic pigment (B) having a small mean particle diameter preferably has a mean particle diameter (DB) of 10 nm to 800 nm, and more preferably has a mean particle diameter within the range of 250 nm to 600 nm.

The inorganic pigments incorporated in the coating liquid are preferably such that the weight ratio (WB/WA) of the added amount (WB) of the inorganic pigment (B) having a small mean particle diameter to the added amount (WA) of the inorganic pigment (A) having a large mean particle diameter is preferably within the range of 2.0 to 15.0 and more preferably within the range of 3.0 to 10.0. If the weight ratio (WB/WA) is within the range of 2.0 to 15.0, a dense structure is formed in the fluorine resin layer 22 in which the inorganic pigment (B) having a small mean particle diameter is incorporated in gaps between the inorganic pigment (A) having a large mean particle diameter as shown in FIG. 2. If the weight ratio (WB/WA) is outside the aforementioned range, it becomes difficult for the inorganic pigments to form a dense structure in the fluorine resin layer 22, thereby resulting in a decrease in gas barrier properties of the back sheet 20.

There are no particular limitations on the inorganic pigments (A) and (B) provided they do not impair the effects of the present invention, and pigments that have favorable dispersibility in the fluorine resin layer 22, allow the obtaining of high reflectance, and allow the formation of the fluorine resin layer 22 having superior durability are preferable, examples of which include titanium dioxide, surface-treated titanium dioxide, carbon black, mica, boron nitride, zinc oxide, aluminum oxide, silica and surface-treated silica, with titanium dioxide, surface-treated titanium dioxide, silica and surface-treated silica being more preferable. These inorganic pigments may be used alone or two or more types may be used in combination.

The surfaces of inorganic pigments (A) and (B) incorporated in the coating liquid are preferably subjected to organic treatment or inorganic treatment with polydimethylsiloxane or a silane coupling agent and the like. The use of such surface-treated inorganic pigments results in favorable dispersibility of the inorganic pigments in the coating liquid and favorable coating aptitude of the coating liquid in which they are incorporated.

In addition to the aforementioned fluorine-containing polymer, the inorganic pigments (A) and (B) and the solvent, an additive such as a curing agent (crosslinking agent), crosslinking promoter, ultraviolet absorber, plasticizer or antioxidant can also be contained in the coating liquid.

Examples of crosslinking promoters used include dibutyltin dilaurate and dioctyltin dilaurate, and these crosslinking promoters are used to promote crosslinking between the fluorine-containing resin and isocyanate.

There are no particular limitations on the composition of the coating liquid provided it allows the effects of the present invention to be adequately demonstrated. One example of the composition of the coating liquid is a coating liquid that incorporates a total of 50 parts by weight to 130 parts by weight of the inorganic pigments (A) and (B), 5 parts by weight to 20 parts by weight of a curing agent, 0.0001 parts by weight to 0.01 parts by weight of a crosslinking promoter and 50 parts by weight to 250 parts by weight of a solvent such as methyl ethyl ketone to 100 parts by weight of the fluorine-containing polymer such as the aforementioned chlorotrifluoroethylene (CTFE)-based copolymer in terms of the solid fraction thereof.

A conventionally known method can be used to coat the coating liquid onto the base sheet 21, examples of which include bar coating, reverse roll coating, knife coating, roll knife coating, gravure coating, air doctor coating and doctor blade coating, and coating is carried out so as to reach a desired film thickness.
There are no particular limitations on the film thickness of the fluorine resin layer 22 formed by curing the coating liquid, and is, for example, 5 µm or more. From the viewpoints of water vapor impermeability, weather resistance and light weight, the film thickness of the fluorine resin layer 22 is preferably 5 µm to 100 µm, more preferably 8 µm to 50 µm, and even more preferably 10 µm to 40 µm.
The temperature during the drying process of the coated coating liquid is a temperature that does not impair the effects of the present invention, and from the viewpoint of reducing the effect on the base sheet 21, is preferably within the range of about 50°C to 150°C.

The adhesive layer 23 is preferably a thermoplastic resin from the viewpoint of improving adhesion with the encapsulant 30 when laminating onto the back of the solar cell module 50 in the case of using as a back sheet, and examples thereof include polyethylene resin, polypropylene resin, vinylidene chloride resin, vinyl chloride resin, fluorine resin, acetal-based resin, acrylonitrile-styrene copolymer resin (AS resin), acrylonitrile-butadiene-styrene copolymer resin (ABS resin), methyl methacrylate-butadiene-styrene copolymer resin (MBS resin), acrylurethane resin, ethylene-vinyl acetate copolymer (EVA), ethylene-methacrylic acid copolymer (EMMA), and ionomer resins in which ethylene-methacrylic acid copolymer is crosslinked with metal ions there between. Moreover, the adhesive layer 23 preferably has thermal adhesiveness so as to be able to adhere to the encapsulant when heated. Here, thermal adhesiveness refers to a property enabling the demonstration of adhesiveness as a result of heating treatment. The temperature of the heating treatment is normally within the range of 50°C to 200°C. From the viewpoint of having thermal adhesiveness, the adhesive layer 23 is preferably a resin composed of one type selected from the group consisting of ethylene-vinyl acetate copolymer (EVA), ethylene-methacrylic acid copolymer (EMAA), ionomer resin and a mixture thereof.
In general, the encapsulant 30 is frequently a sealing resin composed of EVA, and in this case, adhesion between the encapsulant 30 and the adhesive layer 23 can be improved by making the resin layer 23 a resin composed of a polymer mainly composed of EVA.

There are no particular limitations on the thickness of the adhesive layer 23 provided it does not impair the effects of the present invention. More specifically, in the case the base resin of the adhesive layer 23 is EVA, the thickness thereof is preferably within the range of 10 µm to 200 µm, and more preferably within the range of 20 µm to 150 µm, from the viewpoints of light weight, electrical insulating properties and the like.

Other polymers and various types of compounding agents may be added to the adhesive layer 23 as necessary. Soft polymers and other organic polymer fillers are used for the other polymers.
In addition, the various types of compounding agents may be organic compounds or inorganic compounds, and compounding agents are used that are commonly used in the resin industry. Examples of compounding agents used include anti-aging agents, stabilizers, pigments such as titanium dioxide, flame retardants, plasticizers, nucleating agents, hydrochloric acid absorbers, antistatic agents, inorganic fillers, lubricants, blocking preventive agents and ultraviolet absorbers.

In the back sheet of the present invention, the fluorine resin layer 22 may be laminated onto one side of the base sheet 21, and the adhesive layer 23 may be laminated onto the other side of the base sheet 21 through the laminating adhesive layer 24 (FIG. 1B). Examples of adhesives used in the laminating adhesive layer 24 include acrylic-based adhesives, urethane-based adhesives, epoxy-based adhesives and ester-based adhesives. One type of these adhesives may be used alone or two or more types may be used in combination.

Since the back sheet 20 of the present embodiment is composed such that the inorganic pigment (A) having a large mean particle diameter and the inorganic pigment (B) having a small mean particle diameter are contained in the fluorine resin layer 22, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments (A) and (B) is 50 parts by weight to 130 parts by weight based on 100 parts by weight of the fluorine resin, when forming the fluorine resin layer 22 by coating a coating liquid containing the fluorine resin and the inorganic pigments (A) and (B) onto the base sheet 21, a denser structure can be formed than in the case of using a coating liquid containing inorganic pigment having a single diameter, thereby making it possible to form the fluorine resin layer 22 having high gas barrier properties.
In addition, in the case of increasing the inorganic pigment content of a coating liquid in order to form a dense structure using inorganic pigment of a single diameter, the viscosity of the coating liquid becomes extremely high, resulting in poor coating aptitude and causing the formation of streaks and air bubbles, whereas according to the present invention, since the inorganic pigments (A) and (B) having different mean particle diameters are contained in the fluorine resin layer(22), a dense structure can be formed without having to excessively increase the inorganic pigment content in the coating liquid, thereby preventing the viscosity of the coating liquid from becoming excessively high and resulting in favorable coating aptitude.
Moreover, the back sheet 20 of the present embodiment has superior blocking properties on the side of the fluorine resin layer, and even in the case of winding the sheet into a roll and storing, the sheet is resistant to the occurrence of blocking even when unwound.

As shown in FIG. 3, the solar cell module of the present invention has the aforementioned back sheet 20 adhered to the encapsulant 30 on the back (back side) of the solar cell module 50.
There are no particular limitations on the type or structure of the solar cell module 50, and can be an amorphous silicon solar cell, crystalline silicon solar cell, microcrystalline silicon solar cell, gallium arsenide or other compound semiconductor solar cell, or dye-sensitized solar cell.
As a result of being provided with the back sheet 20 on the back (back side) of the module, the solar cell module of the present invention has superior water vapor impermeability and weather resistance, and retains durability enabling it to withstand long-term, outdoor use.

### Examples

The following inorganic pigments were incorporated in the examples and comparative examples described below.
* Fuji Silysia Chemical Ltd., trade name: "Sylysia 530" (silica having a mean particle diameter of 2700 nm)
* Fuji Silysia Chemical Ltd., trade name: "Sylysia 430" (silica having a mean particle diameter of 4100 nm)
* Fuji Silysia Chemical Ltd., "Sylysia 450" (silica having a mean particle diameter of 8000 nm)
* DuPont Corp., trade name: "Ti-Pure R105" (titanium dioxide having a mean particle diameter of 500 nm)
* Cabot Corp., trade name: "CAB-O-SIL TS-720" (silica having a mean particle diameter of 300 nm)
* Cabot Corp., trade name: "CAB-O-SIL TS-530" (silica having a mean particle diameter of 420 nm)

### Example 1

### [Coating Liquid for Forming Fluorine Resin Layer]

Each of the following materials:
* 100 parts by weight of chlorotrifluoroethylene-based copolymer (trade name: "Lumiflon LF200", solid fraction concentration: 60% by weight),
* 5 parts by weight of inorganic pigment (trade name: "Sylysia 450"),
* 36.5 parts by weight of inorganic pigment (trade name: "Ti-Pure R105"),
* 5 parts by weight of inorganic pigment (trade name: "CAB-O-SIL TS-720"),
* 10.7 parts by weight of aliphatic isocyanate crosslinking agent (Sumika Bayer Urethane Co., Ltd., trade name: "Sumidur N3300", solid fraction concentration: 100% by weight),
* 0.0001 parts by weight of crosslinking promoter (dioctyltin dilaurate), and
* 154 parts by weight of methyl ethyl ketone
were blended and dispersed using a T.K. Homodisperser (Primix Corp.) to prepare a coating liquid for forming a fluorine resin layer.

### [Coating Liquid for Forming Adhesive Layer]

90 parts by weight of a main agent in the form of a urethane-based adhesive (Mitsui Chemicals, Inc., trade name: Takelac A-515) and 10 parts by weight of a curing agent (Mitsui Chemicals, Inc., trade name: Takenate A-3) were mixed to obtain a coating liquid for forming an adhesive layer.

The coating liquid for forming the fluorine resin layer was coated onto one side of a polyethylene terephthalate (PET) film having a thickness of 125 µm (Teijin Dupont Films Japan, Ltd., trade name: "Melinex S") with a bar coater so that the coated film thickness after drying was 15 µm, and then dried for 2 minutes at 120°C to obtain a PET film on which was formed a fluorine resin layer.

The coating film for forming the adhesive layer was coated onto the back side (side on which the fluorine resin layer was not formed) of the resulting PET film on which was formed a fluorine resin layer using a bar coater to a thickness after drying of 5 µm, and an EVA film having a thickness of 100 µm was laminated thereon after drying for 1 minute at 80°C. Subsequently, the laminated PET film was allowed to stand for 7 days in an environment at 23°C and RH of 50% to produce a back sheet.

### Example 2

The back sheet of Example 2 was produced in the same manner as Example 1 with the exception of using "Sylysia 430" instead of "Sylysia 450" used in Example 1.

### Example 3

The back sheet of Example 3 was produced in the same manner as Example 1 with the exception of using 5 parts by weight of "Sylysia 530", 5 parts by weight of "CAB-O-SIL TS-530", and 36.5 parts by weight of "Ti-Pure R105" as inorganic pigments.

### Example 4

The back sheet of Example 4 was produced in the same manner as Example 1 with the exception of using 10 parts by weight of "Sylysia 430", 10 parts by weight of "CAB-O-SIL TS-720", and 36.5 parts by weight of "Ti-Pure R105" as inorganic pigments.

### Example 5

The back sheet of Example 5 was produced in the same manner as Example 1 with the exception of using 15 parts by weight of "Sylysia 430", 15 parts by weight of "CAB-O-SIL TS-720", and 36.5 parts by weight of "Ti-Pure R105" as inorganic pigments.

### Example 6

The back sheet of Example 6 was produced in the same manner as Example 2 with the exception of changing the amount of "Sylysia 430" incorporated as inorganic pigment to 15 parts by weight.

### Example 7

The back sheet of Example 7 was produced in the same manner as Example 1 with the exception of using 5 parts by weight of "Sylysia 430", 15 parts by weight of "CAB-O-SIL TS-720", and 36.5 parts by weight of "Ti-Pure R105" as inorganic pigments.

### Comparative Example 1

The back sheet of Comparative Example 1 was produced in the same manner as Example 1 with the exception of only adding 36.5 parts by weight of "Ti-Pure R105" as inorganic pigment.

### Comparative Example 2

The back sheet of Example 4 was produced in the same manner as Example 1 with the exception of using 45 parts by weight of "Sylysia 430", 45 parts by weight of "CAB-O-SIL TS-720", and 36.5 parts by weight of "Ti-Pure R105" as inorganic pigments.

The mean particle diameters, diameter ratios (DB/DA), added amounts, addition ratios (WB/WA) and ratios of fluorine resin to inorganic pigments of the inorganic pigments used in the coating liquids prepared in the aforementioned Examples 1 to 7 and Comparative Examples 1 and 2 are summarized in Table 1.

**Table 1**

| | Inorganic pigment mean particle diameter (nm) | | DB/DA | Inorganic pigment added amount (parts by weight) | | WB/WA | Fluorine resin: inorganic pigment (solid fraction ratio) |
|---|---|---|---|---|---|---|---|
| | Inorganic pigment having large particle diameter (DA) | Inorganic pigment having small particle diameter (DB) | | Inorganic pigment having large particle diameter (WA) | Inorganic pigment having small particle diameter (WB) | | |
| Ex.1 | 8000 | 300,500 | 0.04,0.06 | 5.0 | 41.5 | 8.3 | 100:78 |
| Ex.2 | 4100 | 300,500 | 0.07,0.12 | 5.0 | 41.5 | 8.3 | 100:78 |
| Ex.3 | 2700 | 420,500 | 0.16,0.19 | 5.0 | 41.5 | 8.3 | 100:78 |
| Ex.4 | 4100 | 300,500 | 0.07,0.12 | 10.0 | 46.5 | 4.7 | 100:94 |
| Ex.5 | 4100 | 300,500 | 0.07,0.12 | 15.0 | 51.5 | 3.4 | 100:110 |
| Ex.6 | 4100 | 300,500 | 0.07,0.12 | 15.0 | 41.5 | 2.8 | 100:94 |
| Ex.7 | 4100 | 300,500 | 0.07,0.12 | 5.0 | 51.5 | 10.3 | 100:94 |
| Comp. Ex.1 | -- | 500 | -- | -- | 36.5 | -- | 100:61 |
| Comp. Ex.2 | 4100 | 300,500 | 0.07,0.12 | 45.0 | 81.5 | 1.8 | 100:210 |

Each of the back sheets of Examples 1 to 7 and Comparative Examples 1 and 2 prepared in the manner described above were measured for water vapor permeability, blocking and status of coated surface.
These measurements were carried out in the manner described below. The measurement results are summarized in Table 2.

### <Measurement of Water Vapor Permeability>

The produced back sheets were cut to 90 mm x 90 mm, and the water vapor permeability of the test pieces was measured under conditions of 40°C and 90% RH using a water vapor permeability measuring instrument (Mocon Ltd., Permatran-W® 3/33) in accordance with ASTM F1249.

### <Blocking>

The produced back sheets were cut out to A4 size (297 mm long x 210 mm wide). After layering 10 of the cut out sheets so that side with the fluorine resin layer contacted the side not having the fluorine resin layer, the top and bottom sheets were placed between A4 size vinyl chloride boards having a thickness of 3 mm, a 1 kg weight was placed thereon followed by storing for 7 days in a constant temperature, constant humidity bath at 40°C and 80% RH, and then storing for 1 hour in a constant temperature and humidity chamber at 23°C and 50% RH. Next, the sheets were separated manually starting with the top sheet, and the sheets were evaluated as to whether or not they were resistant to separation at their lamination interfaces according to the evaluation criteria indicated below.
A: Not resistant to separation and favorable appearance of fluorine resin layer (no blocking)
B: Resistant to separation and poor appearance due to partial presence of locations having high gloss (frosting) in fluorine-containing resin coating layer (blocking)

### <Coated Surface Status>

After coating the coating liquids for forming a fluorine resin layer prepared in Examples 1 to 7 and Comparative Examples 1 and 2 onto a PET film, the status of the coated surface of the fluorine resin layer after drying was confirmed visually and evaluated in accordance with the evaluation criteria indicated below.
A: Absence of streaks and air bubbles, and favorable coated surface
B: Large number of streaks, air bubbles and other coating defects, and extremely poor coated surface

**[Table 2]**

| | Water vapor permeability (g/m²/24h) | Blocking | Coated surface status |
|---|---|---|---|
| Ex.1 | 87.0 | A | A |
| Ex.2 | 92.0 | A | A |
| Ex.3 | 91.5 | A | A |
| Ex.4 | 85.0 | A | A |
| Ex.5 | 82.5 | A | A |
| Ex.6 | 86.0 | A | A |
| Ex.7 | 89.0 | A | A |
| Comp.Ex.1 | 157.0 | B | A |
| Comp.Ex.2 | 124.0 | A | B |

According to the results of Table 2, the back sheets of Examples 1 to 7 according to the present invention were determined to have lower water vapor permeability than the back sheets of the comparative examples and demonstrate superior water vapor impermeability.
In addition, the back sheets of Examples 1 to 7 also demonstrated superior blocking properties, and the status of the coated surface of the fluorine resin layer was determined to be favorable.

On the other hand, in the back sheet of Comparative Example 1 incorporating 36.5 parts by weight of an inorganic pigment having a single particle diameter in the fluorine resin layer, water vapor permeability was high and blocking was poor.
In addition, in the back sheet of Comparative Example 2 incorporating a total of 126.5 parts by weight of inorganic pigment, coated surface status was poor, and water vapor permeability increased as a result thereof.

### INDUSTRIAL APPLICABILITY

The back sheet of the present invention has superior gas barrier properties, can be produced easily and inexpensively, and is useful as a back sheet for a solar cell module.

### BRIEF DESCRIPTION OF REFERENCE SYMBOLS

- 10:: Front protective sheet
- 20:: Back protective sheet (back sheet)
- 21:: Base sheet
- 22:: Fluorine resin layer
- 23:: Adhesive layer
- 24:: Laminating adhesive layer
- A:: Inorganic pigment having large mean particle diameter
- B:: Inorganic pigment having small mean particle diameter
- 30:: Encapsulant
- 40:: Solar cell
- 50:: Solar cell module

## Claims

1. A back protective sheet for a solar cell module in which a fluorine resin layer is formed on at least one side of a base sheet; wherein,
an inorganic pigment (A) having a large mean particle diameter and an inorganic pigment (B) having a small mean particle diameter are contained in the fluorine resin layer, the diameter ratio (DB/DA) of the mean particle diameter (DB) of the inorganic pigment (B) to the mean particle diameter (DA) of the inorganic pigment (A) is within the range of 0.01 to 0.3, and the total amount of the inorganic pigments (A) and (B) is within the range of 50 parts by weight to 130 parts by weight based on 100 parts by weight of the fluorine resin.

2. The back protective sheet for a solar cell module according to claim 1, wherein the mean particle diameter (DA) of the inorganic pigment (A) having a large mean particle diameter is within the range of 1,500 nm to 12,000 nm, and the mean particle diameter (DB) of the inorganic pigment (B) having a small mean particle diameter is within the range of 10 nm to 800 nm.

3. The back protective sheet for a solar cell module according to claim 1, wherein the weight ratio (WB/WA) of the added amount (WB) of the inorganic pigment (B) having a small mean particle diameter to the added amount (WA) of the inorganic pigment (A) having a large mean particle diameter is within the range of 2.0 to 15.0.

4. The back protective sheet for a solar cell module according to claim 1, wherein the inorganic pigments (A) and (B) are one type or two or more types selected from the group consisting of titanium dioxide, surface-treated titanium dioxide, silica and surface-treated silica.

5. A solar cell module provided with the back protective sheet for a solar cell module according to any of claims 1 to 4 on the back side thereof.
